# EUROPÄISCHE PATENTSCHRIFT

(11) **EP 1 354 077 B1**
(45) Veröffentlichungstag und Bekanntmachung des Hinweises auf die Patenterteilung: **16.08.2006**
(21) Anmeldenummer: 01911390.1
(22) Anmeldetag: 23.01.2001
(51) Int. Cl.: C25D 5/16, C25D 3/12

(54) **VERFAHREN UND VORRICHTUNG ZUR KONTINUIERLICHEN ABSCHEIDUNG EINES NICKELHALTIGEN BELAGES AUF EINER METALLFOLIE**
METHOD AND APPARATUS FOR THE CONTINUOUS DEPOSITION OF A NICKEL-CONTAINING COATING ON A METALLIC FILM
DISPOSITIF ET PROCEDE POUR LE DEPOT EN CONTINU D'UNE COUCHE CONTENANT DU NICKEL SUR UNE FEUILLE METALLIQUE

(43) Veröffentlichungstag der Anmeldung: 22.10.2003
(73) Patentinhaber: Bolta-Werke GmbH, 91227 Leinburg (DE)
(72) Erfinder: SCHMIDT, Cordt, 98693 Ilmenau (DE); HACKERT, Jürgen, 08223 Grünbach (DE)
(74) Vertreter: Hiebsch, Gerhard F.
(86) Internationale Anmeldenummer: PCT/DE2001/000290
(87) Internationale Veröffentlichungsnummer: WO 2002/059397

(56) Entgegenhaltungen:
- US-A- 4 006 064
- US-A- 4 411 744
- US-A- 4 663 256

## Beschreibung

Die Erfindung betrifft ein Verfahren zur kontinuierlichen haftfesten elektrolytischen Abscheidung eines salzfreien dendritischen nickelhaltigen Belages auf einer Metallfolie, insbesondere einer Nickelfolie.

Es ist bekannt, Metallfolien in einem kontinuierlichen Verfahren durch elektrochemische oder chemische Behandlung mit einem Haftbelag zu versehen. Metallfolien mit Haftbelägen kommen bei der Herstellung metallkaschierter Verbundmaterialien für die Leiterplattenindustrie od.dgl. zur Anwendung. Bekanntermaßen wird durch anodische oder kathodische Behandlung die Oberfläche der Metallfolie aufgerauht und somit vergrößert. Hierdurch wird beim Verbinden der Metallfolie mit einem Kunststoffsubstrat eine formschlüssige Haftung erreicht. Bevorzugt wird die kathodische Behandlung von Metallfolien angewandt. Nach diesem Prinzip wird bei überkritischen Stromdichten im sog. Diffusionsgrenzstromdichtebereich auf der Metallfolie ein dendritischer Belag erzeugt, der für eine haftfeste Verbindung der Metallfolie mit dem Kunststoffsubstrat eine günstige Oberflächenrauheit schafft. Auf diesem Prinzip beruhend, werden bislang insbesondere kupferhaltige Beläge mit Hilfe unterschiedlicher Verfahrensvarianten hergestellt.

Die Beschichtung von Metallfolien mit nickelhaltigen Belägen lässt sich nach diesem, beispielsweise aus US 4,663,256, bekannten Prinzip bislang jedoch nicht realisieren. Die Einstellung überkritischer Stromdichten zur Erzeugung dendritischer Beläge ist bei der elektrolytischen Nickelabscheidung aus bekannten Elektrolyten wie beispielweise Sulfat-, Sulfamat-Chlorid, Fluoroborat- oder Sulfat/Chlorid-Elektrolyten nicht möglich, da stoffspezifisch die Nickelabscheidung stets mit einer gleichzeitigen Wasserstoff-Mitabscheidung vonstatten geht. Mit zunehmender Stromdichte erhöht sich die Wasserstoff-Mitabscheidung erheblich, die Nickelausbeute sinkt. Die Nickelbeläge bleiben kompakt und glatt. Infolge der erhöhten wasserstoff-Mitabscheidung steigt der pH-Wert des jeweiligen Elektrolyten stark an. Der pH-Wertanstieg bedingt die Fällung von Nickelhydroxyd, das sich an der Oberfläche der Metallfolie absetzt und zur Ausbildung salzhaltiger spröder Nickelbeläge führt. Gleichzeitig wird durch die Wasserstoffgasentwicklung ein konvektiver Stoffaustausch erzwungen, der die Einstellung überkritischer Stromdichten und damit eine Abscheidung dendritischer nickelhaltiger Beläge im Diffusionsgrenzstromdichtebereich verhindern. Auch durch Absenken des Nickelgehaltes im Elektrolyten lassen sich keine dendritische Beläge erzeugen, da in diesem Falle eine intensive Wasserstoff-Mitabscheidung mit analogen Auswirkungen bereits bei entsprechend niedrigeren Stromdichten einsetzt und sich auf der Oberfläche der Metallfolie ebenfalls nur nickelsalzhaltige Beläge bilden.

In Kenntnis dieser Gegebenheiten liegt der Erfindung die Aufgabe zugrunde, die oben genannten Nachteile zu beseitigen, d.h. ein Verfahren der eingangs genannten Art zu schaffen, mit dessen Hilfe sich nickelhaltige Beläge, die aus isolierten, fest auf der Oberfläche der Metallfolie aufgewachsenen dendritischen Gebilden bestehen, kontinuierlich auf eine Metallfolie, insbesondere Nickelfolie, elektrolytisch abscheiden lassen.

Diese Aufgabe wird erfindungsgemäß durch die Merkmale des Anspruches 1 gelöst. Bevorzugte Weiterbildungen des erfindungsgemäßen Verfahrens sind in den Unteransprüchen gekennzeichnet.

Das erfindungsgemäße Verfahren weist den Vorteil auf, dass auf einer relativ glatten Metallfolie, insbesondere Nickelfolie, eine Topografie hergestellt wird, die ideale Voraussetzungen für eine stabile formschlüssige Verbindung der Metallfolie mit einem entsprechenden Kunststoffsubstrat schafft.

Es wurde gefunden, dass sich aus wässrigen Abscheidungs-Lösungen, die 1 bis 20 g/l Nickel, gelöst in Form eines Nickelsulfathydrats, enthalten und die gleichzeitig einen jeweils auf die vorhandene Nickelkonzentration bezogenen mehrfach höheren Gehalt eines gelösten Anunvniumsulfatsalzes besitzen, dendritische nickelhaltige Beläge, ohne Störung durch die gleichzeitig ablaufende Wasserstoff-Mitabscheidung, auf Metallfolien, insbesondere auf Nickelfolien, erzeugen lassen. Infolge der Komplexbildung erfolgt die Nickelionenentladung über eine vorgelagerte Dekomplexierungsreaktion im Reaktionsgrenzstromdichtebereich. Dafür wird erfindungsgemäß der pH-Wert der Abscheidungs-Lösung zwischen pH=5 bis pH=7 und die Temperatur der Abscheidungs-Lösung zwischen 20°C und 40°C und werden zunächst zeitweilig überkritische kathodische Stromdichten j₁ von j₁=2 bis 10 A/dm² und danach zeitweilig unterkritische Stromdichten j₂ von j₂=0,1 1 bis 1 A/dm2 in wechselnder Folge eingestellt. Die Lösung kann sich dabei in Ruhe befinden, aber auch intensiv bewegt werden. Bevorzugt ist eine starke turbulente Strömung der Abscheidungs-Lösung zur Erzeugung eines intensiven Stoffübergangs an der zu beschichtenden Oberfläche der Metallfolie. Die bei dem erfindungsgemäßen Verfahren zur Anwendung gelangende Abscheidungs-Lösung enthält außerdem noch einen gelösten chloridhaltigen Zusatz in Form von 1 bis 10 g/l Natrium- oder Kaliumchlorid sowie 0,1 bis 0,5 mg/l eines fluorierten Ammoniumsulfonatzusatzes.

Um eine haftfeste Abscheidung der dendritischen Gebilde auf der Oberfläche der Metallfolie, insbesondere Nickelfolie, zu erreichen, ist es bevorzugt, die Metallfolie zuvor in einer salzsauren Aktivierungsstufe, d.h. in einer Salzsäure enthaltenden Lösung von > 0,1 mol/l chemisch oder elektrochemisch zu aktivieren und nach einem sich daran anschließenden kurzen Spülvorgang unmittelbar durch die Behandlungs-d.h. Abscheidungs-Lösung hindurchzuleiten.

Für die Erzeugung haftfester, kompakter dendritischer Beläge und zur Vermeidung von Pulverbildung sind abhängig von der angestrebten Belagsdicke sowie der gewählten jeweiligen Stromdichte erfindungsgemäß eine zeitweilige Dauer der überkritischen Stromdichte j₁ von mindestens zehn Sekunden bis maximal fünf Minuten einzustellen und die zeitweilige Dauer der unterkritischen Stromdichte j₂ auf das 0,5 bis 5-fache der zeitweiligen Dauer der überkritischen Stromdichte j₁ festzulegen. Insbesondere zur Erzeugung dickerer Beläge von > 5µm ist eine mehrfach wechselnde Folge zeitweiliger überkritischer kathodischer Stromdichten j₁ und unterkritischer kathodischer Stromdichten j₂ notwendig. Die Anzahl der wechselnden Folgen der kathodischen Stromdichten j₁ und j₂ muß mindestens eine Folge, zweckmäßigerweise jedoch zwei bis beliebig viele Folgen betragen.

Ein stabiler Beschichtungsbetrieb ist erfindungsgemäß insbesondere dadurch gewährleistbar, daß als Gegenelektroden lösliche und unlösliche Anoden verwendet werden und dabei mindestens eine lösliche Nickelanode mit mindestens einer unlöslichen Anode kombiniert wird.

Die zur Durchführung des erfindungsgemäßen Verfahrens zur Anwendung gelangende erfindungsgemäße Vorrichtung basiert darauf, daß die mit einem nickelhaltigen dendritischen Belag haftfest zu beschichtenden und zu diesem Zwecke kathodisch geschalteten Metallfolien, insbesondere Nickelfolien, nach Durchlaufen einer salzsauren Aktivierungsstufe mit anschließender Spülung unmittelbar mittels einer Walze durch einen die Abscheidungs-Lösung enthaltenden Beschichtungsbehälter geführt werden, in dem zylindersymmetrisch zur Walze vorzugsweise zuerst großflächige lösliche Anoden und danach kleinflächigere unlösliche Anoden in wechselnder Reihenfolge so angeordnet sind, daß die Metallfolien, insbesondere Nickelfolien, im Einflußbereich der großflächigen löslichen Anoden bei Stromdichten von 2 bis 10 A/dm² mit dendritischen nickelhaltigen Belägen beschichtet und danach diese Beläge im Einflußbereich der unlöslichen Anoden bei Stromdichten von 0,1 bis 2 A/dm², vorzugsweise 0,25 bis 1 A/dm², auf den Metallfolien haftfest fixiert werden. Zur optimalen Durchführung des erfindungsgemäßen Verfahrens ist die Vorrichtung hinsichtlich Abstand, Abmessung und Anordnung der Anoden so dimensioniert, daß die das erfindungsgemäße Verfahren kennzeichnenden Stromdichteparameter realisiert werden. Als lösliche Anoden eignen sich beispielsweise mit Nickelgranulat gefüllte Titankörbe. Als unlösliche Anoden können platinierte Titanbleche zur Anwendung gelangen. Die Anoden sind derartig ausgelegt, daß im Beschichtungsbereich zwischen der Walze mit der zu beschichtenden Metallfolie und den Anoden eine quasi zylindersymmetrische Verteilung des elektrischen Feldes erreicht wird. Abhängig von der jeweils gewünschten Belagdicke und dem Durchmesser der verwendeten Walze werden über einen geeigneten Antrieb die Durchzugsgeschwindigkeiten der zu beschichtenden Metallfolie vorgegeben.

Das erfindungsgemäße Verfahren weist den Vorteil auf, daß mit ihm Metallfolien, insbesondere Nickelfolien, mit dendritischen nickelhaltigen Belägen haftfest versehen werden, die beim Verbinden der Metallfolien mit Kunststoffsubstraten zu einer formschlüssigen Haftung hoher Schälfestigkeit führen.

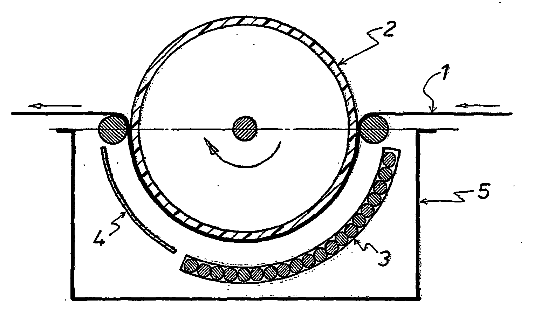

Weitere Einzelheiten, Merkmale und Vorteile ergeben sich aus der nachfolgenden Beschreibung eines in der Zeichnung schematisch dargestellten Ausführungsbeispieles einer Vorrichtung zur Durchführung des erfindungsgemäßen Verfahrens.

Die Figur zeigt eine als Kathode geschaltete Nickelfolie 1, die zur einseitigen kontinuierlichen Beschichtung mit dendritischen nickelhaltigen Belägen an einer elektrisch isolierten rotierenden Walze 2 anliegend durch einen Beschichtungsbehälter 5 an als Anoden geschalteten, zylindersymmetrisch gestalteten Gegenelektroden 3 und 4 vorbeigeführt wird. Die Gegenelektrode 3 ist von einem mit einem Nickelgranulat gefüllten Titankorb als lösliche Anode ausgebildet. Die Gegenelektrode 4 ist von einem platinierten Titanblech als unlösliche Anode ausgebildet.

Für die Beschichtung der Nickelfolie 1 mit einem dendritischen nickelhaltigen Belag wird im Beschichtungsbehälter 5 eine Beschichtungs- d.h. Abscheidungs-Lösung der folgenden Zusammensetzung verwendet:
10 bis 20 g/l NiSO₄ • 6H₂O
30 bis 50 g/l NH₄SO₄
1 bis 3 g/l NaCl
0,1 bis 0, 3 mg/l Tetraethylammoniumperfluoroktansulfonat.

Es werden folgende Abscheidungsparameter eingestellt:
Temperatur der Abscheidungslösung T = 25 bis 30°C
pH-Wert = 6 bis 7
Stromdichte j₁ an der löslichen Anode 3 (über eine erste Stromversorgung):
   j₁ = 5 bis 7 A/dm²
Stromdichte j₂ an der unlöslichen Anode 4 (über eine zweite Stromversorgung):
   j₂ = 0,5 bis 1 A/dm².

Bei einem Durchmesser der Walze 2 von beispielsweise 1000 mm und einer Eintauchtiefe der Walze 2 in die Beschichtungs- d.h. Abscheidungs-Lösung von ca. 1/3 lassen sich unter den oben angegebenen Bedingungen bzw. Parametern bei einer Durchzugsgeschwindigkeit der Nickelfolie 1 von ca. 10 bis 15 m/h dendritische nickelhaltige Beläge mit einem typischen dendritischen Erscheinungsbild mit einer Dicke von 5 bis 6 µm haftfest auf der den Anoden 3 und 4 zugewandten Oberfläche der Nickelfolie 1 abscheiden.

## Patentansprüche

1. Verfahren zur kontinuierlichen haftfesten elektrolytischen Abscheidung eines salzfreien dendritischen nickelhaltigen Belages auf einer Metallfolie (1), insbesondere einer Nickelfolie,
**dadurch gekennzeichnet,**
**dass** die Abscheidung aus einer wässrigen Abscheidungslösung erfolgt, die 1 bis 20 g/l Nickel, gelöst in Form von Nickelsulfathydrat einen auf die vorhandene Nickelkonzentration bezogenen zwei- bis zehnfachen Gehalt von gelöstem Ammoniumsulfatsalz, einen gelösten chloridhaltigen Zusatz in Form von 1 bis 10 g/l Natrium- oder Kaliumchlorid und einen Zusatz von. 0,1 bis 0,5 mg/l eines fluorierten Ammoniumsulfonats enthält, wobei die wässrige Lösung einen pH-Wert von 5 bis 7 sowie eine Temperatur von 20 bis 40°C aufweist und die kathodischen Stromdichten (j) zeitweilig zunächst (j₁) = 2 bis 10 A/dm² im Bereich wenigstens einer löslichen Anode zum Beschichten mit dem dendritischen Belag beträgt sowie danach zeitweilig (j₂) = 0,1 bis 1 A/dm² zum haftfesten Fixieren im Bereich zumindest einer unlöslichen Anode.

2. Verfahren nach Anspruch 1, **dadurch gekennzeichnet, dass** die kathodischen Stromdichten (j₁) und (j₂) in wechselnder Folge wirksam werden.

3. Verfahren nach Anspruch 1 oder 2, **dadurch gekennzeichnet, dass** die minimale Dauer der Stromdichte (j₁) ≥ 10 Sekunden beträgt.

4. Verfahren nach Anspruch 3, **dadurch gekennzeichnet, dass** die Dauer der Stromdichte (j₁) in Abhängigkeit von der gewünschten Belagdicke auf maximal 5 Minuten verlängerbar ist.

5. Verfahren nach einem der Ansprüche 1 bis 4, **dadurch gekennzeichnet, dass** die zeitweilige Dauer der unterkritischen Stromdichte (jz) das 0,5-fache der zeitweiligen Dauer der überkritischen Stromdichte (j₁) beträgt.

6. Verfahren nach Anspruch 5, **dadurch gekennzeichnet, dass** die zeitweilige Dauer der unterkritischen Stromdichte (j₂) bis auf das 5-fache der zeitweiligen Dauer der überkritischen Stromdichte (j₁) verlängerbar ist.

7. Verfahren nach einem der Ansprüche 2 bis 6, **dadurch gekennzeichnet, dass** in Abhängigkeit von der gewünschten Belagdicke die Anzahl der wechselnden Folgen der kathodischen Stromdichten (j₁) und (j₂) mindestens Eins beträgt oder größer als Eins ist.

8. Verfahren nach einem der Ansprüche 1 bis 7, **dadurch gekennzeichnet, dass** die kathodisch geschaltete Metallfolie (1), insbesondere die Nickelfolie, eine salzsaure Aktivierungsstufe mit anschließender Spülung durchläuft und daran unmittelbar anschließend über eine Walze (2) durch einen die Abscheidungs-Lösung enthaltenden Beschichtungsbehälter (5) geführt wird, in dem zylindersymmetrisch zur Walze (2) zuerst mindestens eine großflächige lösliche Anode (3) und danach mindestens eine kleinflächige unlösliche Anode (4) so angeordnet und über getrennte Stromversorgungen derartig strommäßig versorgt werden, dass die an den Anoden (3, 4) vorbeigeführte Metallfolie (1) zunächst im Einflussbereich der mindestens einen großflächigen löslichen Anode (3) bei der entsprechenden Stromdichte (j₁) mit dem entsprechenden dendritischen nickelhaltigen Belag beschichtet und danach im Einflussbereich der mindestens einen kleinflächigen unlöslichen Anode (4) bei der entsprechenden Stromdichte (j₂) haftfest fixiert wird.

9. Verfahren nach Anspruch 8, **dadurch gekennzeichnet, dass** eine Anzahl großflächiger löslicher Anoden (3) und eine Anzahl kleinflächiger unlöslicher Anoden (4) in wechselnder Reihenfolge so angeordnet und über getrennte Stromversorgungen derartig strommäßig versorgt werden, dass die an den Anoden (3, 4) vorbeigeführte Metallfolie (1) zunächst im Einflussbereich der großflächigen löslichen Anoden (3) bei den entsprechenden Stromdichten (j₁) mit dendritischen nickelhaltigen Belägen beschichtet und danach im Einflussbereich der kleinflächigen unlöslichen Anoden (4) bei den entsprechenden Stromdichten (j₂) haftfest fixiert werden.

10. Verfahren nach Anspruch 9, **dadurch gekennzeichnet, dass** die Dauer der wirksamen Stromdichten (j₁ und j₂) abhängig von der gewünschten Belagdicke über die Durchzugsgeschwindigkeit der Metallfolie (1) durch die im Beschichtungsbehälter (5) befindliche Abscheidungs-Lösung eingestellt und die Anzahl der wechselnden Folgen der Stromdichtebelastungen über die Anzahl der löslichen und unlöslichen Anoden (3 und 4) im Beschichtungsbehälter (5) festgelegt wird.

11. Vorrichtung zur Durchführung des Verfahrens nach einem der voranstehenden Patentansprüche, **gekennzeichnet durch** eine Walze (2) in einem die Abscheidungs-Lösung enthaltenden Beschichtungsbehälter (5), in dem zylindersymmetrisch zur Walze (2) zuerst mindestens eine großflächige lösliche Anode (3) und danach mindestens eine kleinflächige unlösliche Anode (4) angeordnet und über getrennte Stromversorgungen strommäßig versorgt sind.

12. Vorrichtung nach Anspruch 11, **dadurch gekennzeichnet, dass** großflächige lösliche Anoden (3) und kleinflächige unlösliche Anoden (4) in wechselnder Reihenfolge angeordnet sind.

13. Vorrichtung nach Anspruch 11 oder 12, **gekennzeichnet durch** mit Nickelgranulat gefüllte Titankörbe als lösliche Anoden (3).

14. Vorrichtung nach Anspruch 11 oder 12, **gekennzeichnet durch** platinierte Titanbleche als unlösliche Anoden (4).

## Claims

1. Process for the continuous adhesive electrolytic deposition of a salt-free dendritic nickel-containing covering on a metal film (1), in particular a nickel film, **characterised in that** the deposition is effected from an aqueous deposition solution, which contains 1 to 20 g/litre of nickel, dissolved in the form of nickel sulphate hydrate, a two to ten times content of dissolved ammonium sulphate salt relative to the existing nickel concentration, a dissolved chloride-containing additive in the form of 1 to 10 g/litre of sodium or potassium chloride and an additive of 0.1 to 0.5 mg/litre of a fluorinated ammonium sulphonate, wherein the aqueous solution has a pH value of 5 to 7 and a temperature of 20 to 40°C, and the cathodic current densities (j) are temporarily first of all (j₁) = 2 to 10 A/dm² in the region of at least one soluble anode for coating with the dendritic covering and then temporarily (j₂) = 0.1 to 1 A/dm² for adhesive fixing in the region of at least one insoluble anode.

2. Process according to claim 1, **characterised in that** the cathodic current densities (j₁) and (j₂) become effective in alternating sequence.

3. Process according to claim 1 or 2, **characterised in that** the minimum duration of the current density (j₁) is ≥ 10 seconds.

4. Process according to claim 3, **characterised in that** the duration of the current density (j₁) can be extended to a maximum 3 minutes depending on the required covering thickness.

5. Process according to one of claims 1 to 4, **characterised in that** the temporary duration of the sub-critical current density (j₂) is 0.5 times the temporary duration of the super-critical current density (j₁).

6. Process according to claim 5, **characterised in that** the temporary duration of the sub-critical current density (j₂) can be extended to 5 times the temporary duration of the super-critical current density (j₁).

7. Process according to one of claims 2 to 6, **characterised in that** the number of alternating sequences of the cathodic current densities (j₁) and (j₂) is at least one or is greater than 1 depending on the required covering thickness.

8. Process according to one of claims 1 to 7, **characterised in that** the cathodically connected metal foil (1), in particular the nickel foil, passes though a hydrochloric activation stage with subsequent rinsing and directly following that is guided via a roller (2) through a coating container (5) containing the deposition solution, in which first of all at least one large surface area soluble anode (3) and then at least one small surface area insoluble anode (4) are arranged in cylinder-symmetrical manner to the roller (2) and are supplied in terms of current via separate current supplies, such that the metal foil (1) guided past the anodes (3, 4) is first of all coated with the corresponding dendritic, nickel-containing covering in the region of influence of the at least one large surface area soluble anode (3) at the corresponding current density (j₁) and then is adhesively fixed in the region of influence of the at least one small surface area insoluble anode (4) at the corresponding current density (j₂).

9. Process according to claim 8, **characterised in that** a number of large surface area soluble anodes (3) and a number of small surface area insoluble anodes (4) are arranged in alternating sequence and supplied in terms of current via separate current supplies, such that the metal foil (1) guided past the anodes (3, 4) is first of all coated with dendritic, nickel-containing coverings in the region of influence of the large surface area soluble anodes (3) at the corresponding current densities (j₁) and then is adhesively fixed in the region of influence of the small surface area insoluble anodes (4) at the corresponding current densities (j₂).

10. Process according to claim 9, **characterised in that** the duration of the effective current densities (j₁ and j₂) is adjusted depending on the required covering thickness via the passage rate of the metal foil (1) through the deposition solution situated in the coating container (5) and the number of alternating sequences of current density loads is fixed via the number of soluble and insoluble anodes (3 and 4) in the coating container (5).

11. Device for carrying out the process according to one of the above patent claims, **characterised by** a roller (2) in a coating container (5) containing the deposition solution, in which first of all at least one large surface area soluble anode (3) and then at least one small surface area insoluble anode (4) are arranged in cylindrical-symmetrical manner to the roller (2) and are supplied in terms of current via separate current supplies.

12. Device according to claim 11, **characterised in that** large surface area soluble anodes (3) and small surface area insoluble anodes (4) are arranged in alternating sequence.

13. Device according to claim 11 or 12, **characterised by** titanium baskets filled with nickel granules as soluble anodes (3).

14. Device according to claim 11 or 12, **characterised by** platinum-plated titanium sheets as insoluble anodes (4).

## Revendications

1. Procédé de dépôt électrolytique continu adhérent sur une feuille métallique (1), en particulier une feuille de nickel, d'une couche dendritique exempte de sel, et contenant du nickel,
**caractérisé en ce que** le dépôt s'effectue depuis une solution de dépôt aqueuse qui contient de 1 à 20 g/l de nickel, dissous sous forme de sulfate de nickel hydraté, une teneur double à décuple, rapportée à la concentration présente de nickel, de sel de sulfate d'ammonium dissous, un additif dissous contenant des chlorures sous la forme de 1 à 10 g/l de chlorure de sodium ou de potassium et un additif de 0,1 à 0,5 mg/l d'un sulfonate d'ammonium fluoré, dans lequel la solution aqueuse présente un pH de 5 à 7 ainsi qu'une température de 20 à 40 °C et que les densités de courant cathodique (j) sont temporairement d'abord (j₁) = 2 à 10 A/dm² au voisinage d'au moins une anode soluble pour le plaquage par le dépôt dendritique, et ensuite temporairement (j₂) = 0,1 à 1 A/dm² pour la fixation adhérente solide au voisinage d'au moins une anode insoluble.

2. Procédé selon la revendication 1, **caractérisé en ce que** les densités de courant cathodique (j₁) et (j₂) prennent effet alternativement.

3. Procédé selon la revendication 1 ou 2, **caractérisé en ce que** la durée minimale de la densité de courant (j₁) est ≥ 10 secondes.

4. Procédé selon la revendication 3, **caractérisé en ce que** la durée de la densité de courant (j₁) peut être allongée en fonction de l'épaisseur désirée du dépôt jusqu'à 5 minutes au maximum.

5. Procédé selon l'une des revendications 1 à 4, **caractérisé en ce que** la durée temporaire de la densité de courant sous-critique (j₂) est 0,5 fois la durée temporaire de la densité de courant surcritique (j₁).

6. Procédé selon la revendication 5, **caractérisé en ce que** la durée temporaire de la densité de courant sous-critique (j₂) peut être allongée jusqu'à 5 fois la durée temporaire de la densité de courant surcritique (j₁).

7. Procédé selon l'une des revendications 2 à 6, **caractérisé en ce qu'**en fonction de l'épaisseur désirée du dépôt, le nombre des alternances des densités de courant cathodique (j₁) et (j₂) est d'au moins un ou plus grand que un.

8. Procédé selon l'une des revendications 1 à 7, **caractérisé en ce que** la feuille métallique (1) connectée comme cathode, en particulier la feuille de nickel, traverse une étape d'activation à l'acide chlorhydrique suivie d'un rinçage, et qu'elle est ensuite immédiatement acheminée par l'intermédiaire d'un rouleau (2) à travers un récipient de plaquage (5) contenant la solution de dépôt dans lequel, avec symétrie cylindrique par rapport au rouleau (2), d'abord au moins une anode soluble (3) de grande surface et ensuite au moins une anode insoluble (4) de petite surface sont disposées et sont alimentées en courant par des alimentations en courant séparées de telle sorte que la feuille métallique (1) acheminée devant les anodes (3, 4) est d'abord plaquée dans la zone d'influence de l'au moins une anode soluble (3) de grande surface sous la densité de courant (j₁) correspondante avec le placage dendritique correspondant contenant du nickel et est ensuite fixée de manière fortement adhérente dans la zone d'influence de l'au moins une anode insoluble (4) de petite surface sous la densité de courant (j₂) correspondante.

9. Procédé selon la revendication 8, **caractérisé en ce qu'**un nombre d'anodes solubles (3) de grande surface et un nombre d'anodes insolubles (4) de petite surface sont disposées dans un ordre alternatif et sont alimentées en courant par des alimentations en courant séparées de telle sorte que la feuille métallique (1) acheminée devant les anodes (3, 4) est d'abord plaquée dans la zone d'influence des anodes solubles (3) de grande surface sous les densités de courant (j₁) correspondantes avec des placages dendritiques contenant du nickel, et est ensuite fixée de manière fortement adhérente dans la zone d'influence des anodes insolubles (4) de petite surface sous les densités de courant (j₂) correspondantes.

10. Procédé selon la revendication 9, **caractérisé en ce que** la durée des densités de courant (j₁ et j₂) efficaces est réglée en fonction de l'épaisseur désirée du dépôt par l'intermédiaire de la vitesse de traction de la feuille métallique (1) à travers la solution de dépôt se trouvant dans le récipient de plaquage (5) et **en ce que** le nombre des alternances des sollicitations de densité de courant est fixé par l'intermédiaire du nombre des anodes solubles et insolubles (3 et 4) dans le récipient de plaquage (5).

11. Dispositif pour la mise en oeuvre du procédé selon l'une des revendications précédentes, **caractérisé par** un rouleau (2) dans un récipient de plaquage (5) contenant la solution de dépôt, récipient dans lequel tout d'abord au moins une anode soluble (3) de grande surface et ensuite au moins une anode insoluble (4) de petite surface sont disposées en symétrie cylindrique par rapport au rouleau (2) et sont alimentées en courant par des alimentations en courant séparées.

12. Dispositif selon la revendication 11, **caractérisé en ce que** des anodes solubles (3) de grande surface et des anodes insolubles (4) de petite surface sont disposées en alternance.

13. Dispositif selon la revendication 11 ou 12, **caractérisé par** des corbeilles en titane remplies de granulé de nickel comme anodes solubles (3).

14. Dispositif selon la revendication 11 ou 12, **caractérisé par** des tôles de titane platinées comme anodes insolubles (4).
